# EUROPÄISCHE PATENTANMELDUNG

(11) **EP 1 694 108 A1**
(43) Veröffentlichungstag der Anmeldung: **23.08.2006**
(21) Anmeldenummer: 05003456.0
(22) Anmeldetag: 17.02.2005
(51) Int. Cl.: H05K 13/02

(54) **Vorrichtung und Verfahren zur Montage von elektronischen Bauteilen auf ein Bauteilreservoir**

(71) Anmelder: KLARER, Christoph, D-82024 Taufkirchen (DE)
(72) Erfinder: KLARER, Christoph, D-82024 Taufkirchen (DE)
(74) Vertreter: Hofstetter, Alfons J.

(57) **Zusammenfassung**

Die vorliegende Erfindung betrifft eine Vorrichtung zur Montage von elektronischen Bauteilen auf ein Bauteilereservoir (29), insbesondere eine vollautomatische Montagevorrichtung zur Herstellung mikrosystemtechnischer Produkte sowie für Montageaufgaben in der Halbleiterindustrie, mit einem ersten Bauteilereservoir (29), welches auf einem ersten Montagetisch (21) ortsfest angeordnet ist und einer Aufnahme- und Transporteinheit (32) mit einem Aufnahme- und Montagewerkzeug (33) zur Aufnahme und zum Transport von elektronischen Bauteilen und zur Montage der elektronischen Bauteile auf dem ersten Bauteilereservoir (29), wobei zumindest das Aufnahme- und Montagewerkzeug (32) relativ zum ersten Bauteilereservoir (29) bewegbar angeordnet ist. Des Weiteren betrifft die Erfindung ein entsprechendes Verfahren.

## Beschreibung

Die vorliegende Erfindung betrifft eine Vorrichtung und ein Verfahren zur Montage von elektronischen Bauteilen auf ein Bauteilereservoir. Insbesondere betrifft die Erfindung eine vollautomatische Montagevorrichtung zur Herstellung mikrosystemtechnischer Produkte sowie für Montageaufgaben in der Halbleiterindustrie.

Montagevorrichtungen und Verfahren zur Montage von Bauteilen im mikrosystemtechnischen Bereich sind in vielfacher Weise bekannt. Ein wesentliches Anforderungskriterium an derartige Vorrichtungen zur Montage von Halbleiter- und Mikrosystembauteilen besteht darin, dass eine sehr hohe Platziergenauigkeit der Bauteile und zusätzlich eine hohe Durchsatzzahl erreicht werden muss. Wesentliche Einflussfaktoren auf diese Anforderungskriterien sind zum Einen die zunehmende Miniaturisierung der Bauteile, eine steigende Bauteilfunktionalität mit dadurch steigender Zahl der externen, insbesondere der elektrischen Anschlüsse sowie funktionsbedingte Präzisionsanforderungen.

Insbesondere für Montagevorrichtungen, bei denen die benötigten und erforderlichen elektronischen Bauteile aus Bauteilereservoirs ausgewählt und übergeben werden, sind sehr hohe Anforderungen gestellt. Aus DE 201 03 184 U1 ist eine Aufnahme- und Übergabevorrichtung bekannt, welche ein Aufnahmewerkzeug aufweist und zur Aufnahme eines Bauteils von einem Bauteileresenroir und zur Übergabe des aufgenommenen Bauteils an ein Montagewerkzeug ausgebildet ist. Die Aufnahme- und Übergabevorrichtung weist des Weiteren ein optisches System zur Aufnahme und Bestimmung einer Relativlage des aufzunehmenden Bauteils auf. Mittels dem optischen System kann die Relativlage des von dem im Aufnahmekopf angeordneten Aufnahmewerkzeugs aufgenommen Bauteils vor der Übergabe an das Montagewerkzeug bestimmt werden. Des Weiteren ist es mit der entsprechenden Anordnung möglich, dass während einer Drehung des Aufnahmekopfs mit dem aufgenommenen Bauteil der Aufnahmekopf aus einer optischen Achse des optischen Systems ausgeschwenkt ist und so eine zeitgleiche Aufnahme und Bestimmung einer Relativlage eines nachfolgend durch den Aufnahmekopf aufzunehmenden Bauteils aus dem Bauteilereservoir ermöglicht wird.

Eine weitere Vorrichtung zur Montage von Bauteilen ist aus EP 1 235 474 A1 bekannt. Die Vorrichtung ist als vollautomatische Montagevorrichtung zur Herstellung mikrosystemtechnischer Produkte sowie für Montageaufgaben in der Halbleiterindustrie ausgebildet. Die Vorrichtung weist einen Montagetisch und einer auf den Montagetisch bewegbar angeordneten Bauteiletransporteinheit auf. Des Weiteren umfasst die Vorrichtung ein Materialtransportsystem zum Transport der mit Bauteilen zu bestückenden Produkte. Ein Montagekopf umfasst ein Transport- und Montagewerkzeug, wobei der Montagekopf an einem quer zur Bewegungsrichtung der Bauteiltransporteinheit bewegbaren ersten Schlitten der Bauteiltransporteinheit angeordnet ist. Darüber hinaus weist die Vorrichtung eine Mess-Station zur Bestimmung der Relativlage eines von dem Transport- und Montagewerkzeug aufgenommenen Bauteils zum Transport- und Montagewerkzeug auf. Die Mess-Station ist derart bewegbar angeordnet, dass das Transport- und Montagewerkzeug mit dem aufgenommenen Bauteil zwischen einer Bauteilaufnahmeposition und einer Bauteilablageposition die Mess-Station überfährt. Ein Nachteil der bekannten Vorrichtungen ist darin zu sehen, dass das Aufnehmen und Übergeben bzw. das Ablegen auf einer entsprechenden Bauteilablageposition relativ lange dauert. Lediglich während dem Transport des aufgenommenen Bauteils wird eine Bestimmung der Relativlage des Bauteils ermittelt, welches für einen nachfolgenden Positioniervorgang bzw. für einen nachfolgenden Vorgang zum entsprechenden Aufnehmen eines Bauteils herangezogen werden kann. Es wird jedoch keine Information dahingehend gewonnen, wie entsprechende Bauteilaufnahmepositionen und Bauteilablagepositionen zu finden sind. Ein wesentlicher Nachteil der dadurch entsteht, ist eine relativ geringe Durchsatzzahl, wodurch sich hohe Montagekosten für die Bauteile ergeben.

Ein weiterer Nachteil bei den bekannten Vorrichtungen und den bekannten Verfahren ist darin zu sehen, dass bei neuartigen Bauteilereservoiren, insbesondere bei 12-Zoll-Wafern, die Transportwege bzw. die Wege von einer Aufnahmeposition zu einer Montageposition relativ groß sind. Daher ist es relativ aufwendig bei derartig großen Bauteilereservoiren eine entsprechende Vorrichtung zu schaffen, bei der die Bauteile schnell transportiert und sicher platziert werden können. Darüber hinaus kann mit den bekannten Vorrichtungen nur eine relativ geringe Durchsatzzahl bei derartig großen Bauteilereservoiren erreicht werden. Dies führt dazu, dass die Montagekosten sehr hoch sind.

Daher ist es Aufgabe der Erfindung, eine Vorrichtung und ein Verfahren zur Montage von elektronischen Bauteilen auf ein Bauteilereservoir zu schaffen, bei dem die Durchsatzzahl erhöht werden kann und dadurch die Montagekosten gesenkt werden können. Darüber hinaus ist es Aufgabe der Erfindung, eine Vorrichtung und ein Verfahren zu schaffen, mit der bzw. mit dem auch bei relativ großen Bauteilereservoiren ein schneller Transport und eine sichere Platzierung der Bauteile ermöglicht werden kann. Diese Aufgabe wird durch eine Vorrichtung, welche die Merkmale nach Patentanspruch 1 aufweist und ein Verfahren, welches die Merkmale nach Patentanspruch 13 aufweist, gelöst.

Eine erfindungsgemäße Vorrichtung ist zur Montage von elektronischen Bauteilen auf ein Bauteilereservoir ausgebildet. Insbesondere ist die Vorrichtung als eine vollautomatische Montagevorrichtung zur Herstellung mikrosystemtechnischer Produkte sowie für Montageaufgaben in der Halbleiterindustrie ausgebildet. Die erfindungsgemäße Vorrichtung umfasst eine erstes Bauteilereservoir, welches auf einem ersten Montagetisch ortsfest angeordnet ist. Des Weiteren umfasst die Vorrichtung eine Aufnahme- und Transporteinheit mit einem Aufnahme- und Montagewerkzeug zur Aufnahme und zum Transport von elektronischen Bauteilen und zur Montage der elektronischen Bauteile auf dem ersten Bauteilereservoir, wobei zumindest das Aufnahme- und Montagewerkzeug relativ zum ersten Bauteilereservoir bewegbar angeordnet ist. Als Bauteilereservoir werden hierbei sowohl mikrosystemtechnische Grundeinheiten verstanden, welche Bauteile enthalten als auch solche, auf denen keine Bauteile vorhanden sind und erst nachfolgend Bauteile montiert bzw. zusätzlich montiert werden. Unter einer Aufnahme- und Transporteinheit wird eine Einheit verstanden, welche sowohl zur Aufnahme, zum Transport, zur Ablage und zur Montage von elektronischen Bauteilen ausgelegt ist.

Durch die erfindungsgemäße Vorrichtung kann erreicht werden, dass eine relativ hohe Durchsatzzahl erzielt werden kann, wodurch sich die Montagekosten der Bauteile wesentlich reduzieren. Insbesondere für große Bauteilereservoire, beispielsweise für 12-Zoll-Wafer, kann dadurch eine höhere Durchsatzzahl erzielt werden. Indem das Bauteilereservoir selbst positionsstabil und nicht bewegbar angeordnet ist, kann ein schnellerer Transport und eine schnellere Platzierung der entsprechenden elektronischen Bauteile auf dem ersten Bauteilereservoir erreicht werden. Diesbezüglich kann dies dadurch erreicht werden, dass die Aufnahme- und Transporteinheit im Allgemeinen schneller bewegbar und sicherer platzierbar ist, als eine Bewegung eines derartig großen Bauteilereservoirs. Darüber hinaus kann durch die ortsfeste Positionierung des Bauteilereservoirs vermieden werden, dass eine sehr aufwendige und stabile Konstruktion bereitgestellt werden muss, welche dann erforderlich wäre, wenn eine Bewegung eines derartig großen Bauteilereservoirs durchgeführt werden sollte.

In vorteilhafter Weise ist das erste Bauteilereservoir im Wesentlichen vertikal angeordnet. Dies ermöglicht eine relativ einfache Positionierung des ersten Bauteilereservoirs im Hinblick auf die Anordnung der Aufnahme- und Transporteinheit und ist darüber hinaus als relativ platzsparende Alternative anzusehen.

Es kann vorgesehen sein, dass die Aufnahme- und Transporteinheit in einer Ebene parallel zum ersten Bauteilereservoir bewegbar angeordnet ist. Insbesondere ist diese Ebene im Wesentlichen vertikal orientiert. Eine Bewegung der Aufnahme- und Transporteinheit relativ zum fest positionierten ersten Bauteilereservoir kann dadurch relativ schnell erfolgen. Diesbezüglich kann vorgesehen sein, dass das Aufnahme- und Montagewerkzeug derart bewegbar in der Aufnahme- und Transporteinheit angeordnet ist, dass eine Rotationsbewegung des Aufnahme- und Montagewerkzeugs in einer Ebene parallel zum ersten Bauteilereservoir durchführbar ist. In dem das Aufnahme- und Montagewerkzeug selbst zusätzlich eine Bewegung ausführen kann, insbesondere eine Rotationsbewegung, kann erreicht werden, dass die Aufnahme, der Transport und die Montage eines elektronischen Bauteils nochmals schneller durchgeführt werden kann.

Indem neben der Bewegung von Teilen der Aufnahme- und Transporteinheit in einer parallelen Ebene zum ersten Bauteilereservoir und zusätzlich dazu die Bewegung des Aufnahme- und Montagewerkzeuges relativ dazu möglich ist, können vielfältigste Bewegungsabläufe realisiert werden und auch Komplexe und relativ lange Transportwege eines elektronischen Bauteils schnellstmöglich durchgeführt werden. Diesbezüglich sei angemerkt, dass das Aufnahme- und Montagewerkzeug ein Aufnahme- und Montageelement aufweist, welches im Wesentlichen senkrecht zum ersten Bauteilereservoir hin orientiert ist. Dieses Aufnahme- und Montageelement ist derart bewegbar in dem Aufnahme- und Montagewerkzeug angeordnet, dass das Aufnahme- und Montageelement in einer Ebene parallel zur Bewegungsebene des Aufnahme- und Montagewerkzeugs bewegbar ist, und auch in senkrechter Richtung zu dieser Ebene bewegbar ist.

Die Aufnahme- und Transporteinheit und der Montagetisch mit dem ersten Bauteilereservoir sind in bevorzugter Weise an separaten Trägerelementen angeordnet. Dadurch kann erreicht werden, dass die Vorrichtung in Modulbauweise ausgestaltet ist und die separaten Trägerelemente mit den entsprechend darauf angeordneten Einheiten in einfacher und schneller Weise ausgetauscht bzw. umgebaut werden können. Darüber hinaus ist durch eine derartige Modulbauweise gewährleistet, dass die Vorrichtung in variabler Weise umgebaut werden kann und situationsabhängig mit benötigten Modulen bereitgestellt werden kann.

Es kann vorgesehen sein, dass der Montagetisch an einem separaten Trägerelement angeordnet ist und der Montagetisch und das Trägerelement Aussparungen aufweisen, wobei der Montagetisch und die Aufnahme- und Transporteinheit derart zueinander angeordnet sind, dass die Aussparungen zumindest teilweise überlappen. In einer vorteilhaften Ausführung sind die Aussparungen kreisrund ausgebildet. Dadurch kann erreicht werden, dass ein auf dem Montagetisch angeordnetes erstes Bauteilereservoir sowohl von seiner Vorderseite als auch von seiner Rückseite betrachtet bzw. im Hinblick auf eine Montage von elektronischen Bauteilen sicher überwacht werden kann. Da die Bauteilereservoire, insbesondere Waferelemente, im allgemeinen als runde Scheiben ausgebildet sind, kann durch eine kreisrunde Ausbildung der Aussparungen erreicht werden, dass einerseits eine sichere und stabile Befestigung auf dem Montagetisch erreicht werden kann und andererseits eine größtmögliche Fläche des Bauteilereservoirs von beiden Seiten eingesehen und überwacht werden kann.

Es kann weiterhin vorgesehen sein, dass die Vorrichtung ein optisches System umfasst, welches in einer Ebene parallel zum ersten Bauteilereservoir angeordnet ist und in dieser Ebene relativ zum ersten Bauteilereservoir bewegbar ist. Das optische System weist in vorteilhafter Weise eine Kamera, insbesondere eine CCD-Kamera auf, welche mit ihrer optischen Achse senkrecht zur Oberfläche des ersten Bauteilereservoirs orientiert ist. Dadurch kann erreicht werden, dass die Oberfläche des Bauteilereservoirs mittels dem optischen System überwacht wird und Aufnahme- und/oder Montagepositionen von elektronisches Bauteilen beobachtet werden können.

Es kann vorgesehen sein, dass das optische System an einem separaten Trägerelement angeordnet ist, insbesondere einem Trägerelement, welches parallel zum ersten Bauteilereservoir und parallel zur Bewegungsebene der Aufnahme- und Transporteinheit angeordnet ist. Des Weiteren kann vorgesehen sein, dass die Aufnahme- und Transporteinheit zwischen dem ersten Bauteilereservoir und dem optischen System angeordnet ist. Diesbezüglich ist eine optimale Bewegung der Aufnahme- und Transporteinheit im Hinblick auf das Aufnehmen, Transportieren und Ablegen bzw. Montieren von elektronischen Bauteilen auf dem ersten Bauteilereservoir und darüber hinaus eine optimale Beobachtung des ersten Bauteilereservoirs durch das optische System gewährleistet.

Es kann vorgesehen sein, dass eine Detektoreinheit an der Seite des ersten Bauteilereservoirs angeordnet ist, welcher der der Aufnahme- und Transporteinheit zugewandten Seite gegenüberliegt. Diesbezüglich wird ermöglicht, dass die Rückseite des ersten Bauteilereservoirs im Hinblick auf die Aufnahmepositionen und/oder die Montagepositionen der elektronischen Bauteile auf der Rückseite überwacht werden. Diesbezüglich kann überwacht werden, inwieweit eine sichere und exakte Platzierung eines elektronischen Bauteils in einer Montageposition durchgeführt ist bzw. gegebenenfalls eine Neuplatzierung oder Fehleranzeige als Information detektiert und weitergegeben werden kann. Insbesondere können derartige Informationen ebenso wie die Informationen des optischen Systems auf der gegenüberliegenden Seite an eine oder mehrere Steuereinheiten übergeben werden, mit denen die erfindungsgemäße Vorrichtung sowie die Bewegungen der entsprechenden Elemente der Vorrichtung gesteuert werden können.

In vorteilhafter Weise ist die Detektoreinheit in einer Ebene parallel zum ersten Bauteilereservoir bewegbar angeordnet und an einem separaten Trägerelement befestigt.
Dadurch kann der modulartige Aufbau der Vorrichtung fortgeführt werden und die einfache und schnelle Möglichkeit eines Umbaus beibehalten werden.

Bei einem erfindungsgemäßen Verfahren zur Montage von elektronischen Bauteilen auf ein Bauteilereservoir wird ein erstes Bauteilereservoir auf einem ersten Montagetisch ortsfest angeordnet. Darüber hinaus wird zumindest eine Aufnahme- und Transporteinheit mit zumindest einem Aufnahme- und Montagewerkzeug zur Aufnahme und zum Transport von elektronischen Bauteilen sowie zur Montage der elektronischen Bauteile auf dem ersten Bauteilereservoir relativ zum ersten Bauteilereservoir bewegt. Indem das Bauteilereservoir fest platziert wird und die Aufnahme- und Transporteinheit relativ dazu eine Bewegung ausführt, kann eine hohe Durchsatzzahl von Bauteilen, insbesondere bei großen Bauteilereservoiren, auf denen eine entsprechende Montage von elektronischen Bauteilen durchgeführt wird, erreicht werden.

Vorteilhafte Ausgestaltungen des erfindungsgemäßen Verfahrens sind in den Unteransprüchen angegeben. Darüber hinaus sind vorteilhafte Ausgestaltungen der erfindungsgemäßen Vorrichtung auch im Sinne von erfindungsgemäßen und vorteilhaften Ausgestaltungen des erfindungsgemäßen Verfahrens anzusehen.

Ein Ausführungsbeispiel der Erfindung wird anhand schematischer Zeichnungen nachfolgend näher erläutert. Es zeigen:
- Figur 1: eine perspektivische Darstellung einer erfindungsgemäßen Vorrichtung von einer ersten Betrachtungsposition;
- Figur 2: eine perspektivische Darstellung der erfindungsgemäßen Vorrichtung; von einer zweiten Betrachtungsposition; und
- Figur 3: eine Schnittdarstellung der erfindungsgemäßen Vorrichtung.

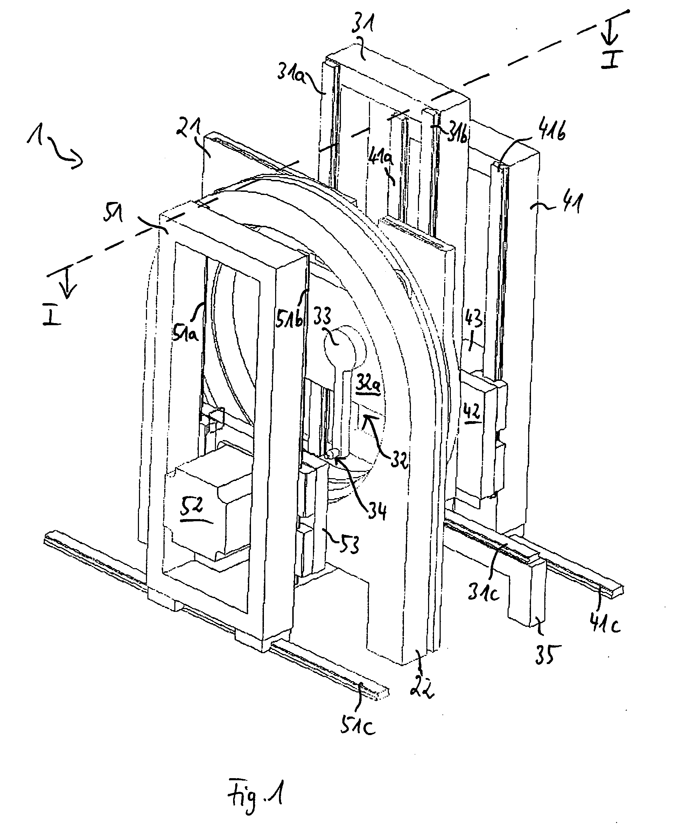

In Figur 1 ist eine erfindungsgemäße Vorrichtung 1 zur Montage von elektronischen Bauteilen auf ein Bauteilereservoir dargestellt. Die erfindungsgemäße Vorrichtung 1 ist im Ausführungsbeispiel als vollautomatische Montagevorrichtung zur Herstellung mikrosystemtechnischer Produkte sowie für Montageaufgaben in der Halbleiterindustrie ausgebildet. Wie aus der Darstellung in Figur 1 gemäß einer ersten Betrachtungsposition zu erkennen ist, weist die Vorrichtung 1 einen Montagetisch 21 auf. Der Montagetisch 21 ist an einem Trägerelement 22 fest positioniert. Wie aus der Darstellung in Figur 1 zu erkennen ist, ist das Trägerelement 22 und der daran angeordnete Montagetisch 21 in vertikaler Richtung orientiert. Auf dem Montagetisch 21 ist auf der dem Trägerelement 22 gegenüberliegenden Seite ein erstes Bauteilereservoir (nicht dargestellt) in vertikaler Richtung ortsfest positioniert. Der Montagetisch 21 und das Trägerelement 22 weisen kreisförmige Aussparungen auf, so dass das auf dem Montagetisch 21 befestigte erste Bauteilereservoir von beiden Seiten des Trägerelements 22 eingesehen werden kann.

Wie aus Figur 1 weiterhin zu erkennen ist, umfasst die erfindungsgemäße Vorrichtung ein Trägerelement 31, an dem eine Aufnahme- und Transporteinheit 32 bewegbar angeordnet ist. Die Aufnahme- und Transporteinheit 32 kann in einer Ebene, welche parallel zum ersten Bauteilereservoir orientiert ist, bewegt werden. Dazu weist die Aufnahme- und Transporteinheit 32 ein erstes Element 32a auf, welches in vertikaler Richtung entlang des Trägerelements 31 an dort vertikal angeordneten Schienen 31 a und 31 b in vertikaler Richtung bewegbar ist. Auf der den Schienen 31 a und 31 b gegenüberliegenden Seite des Teils 32a ist mittig und im Wesentlichen zentriert auf dem plattenförmigen Element 32a im Ausführungsbeispiel ein einziges Aufnahme- und Montagewerkzeug 33 angeordnet. Das Aufnahme- und Montagewerkzeug 33 ist mittels einem zylinderförmigen Endbereich an dem Teil 32a bewegbar befestigt. Das Aufnahme- und Montagewerkzeug 33 ist dabei derart an dem Teil 32a bewegbar angeordnet, dass eine Rotation um die durch den zylinderförmigen Endbereich in horizontaler Richtung verlaufende Drehachse durchgeführt werden kann. Das Aufnahme- und Montagewerkzeug 33 ist somit zur Ausführung einer Drehbewegung an dem Teil 32a angelagert, wobei die Drehbewegung in einer Ebene durchgeführt wird, welche parallel zum ersten Bau- , teilereservoir angeordnet ist. Das Aufnahme- und Montagewerkzeug 33 weist angrenzend an den zylinderförmigen Endbereich einen im Wesentlichen geradlinigen Schenkel auf, an dessen dem zylinderförmigen Endbereich gegenüberliegenden Ende ein Aufnahme- und Montageelement 34 angeordnet ist. Das Aufnahme- und Montageelement 34 ist im Wesentlichen senkrecht zur Oberfläche des ersten Bauteilereservoirs orientiert. Darüber hinaus ist das Aufnahme- und Montageelement 34 bewegbar gegenüber dem Schenkel und dem zylinderförmigen Endbereich des Aufnahme- und Montagewerkzeugs 33 angeordnet. Eine Bewegung des Aufnahme- und Montageelements 34 relativ zu dem Schenkel und dem zylinderförmigen Endbereich des Aufnahme- und Montagewerkzeugs 33 kann dabei in einer Ebene parallel zum ersten Bauteilereservoir und/oder senkrecht zu dieser Ebene, in der das erste Bauteilereservoir angeordnet ist, durchgeführt werden. Es kann auch vorgesehen sein, dass die erfindungsgemäße Vorrichtung mehrere Aufnahme- und Montagewerkzeuge 33 aufweist.

Wie des Weiteren aus Figur 1 zu entnehmen ist, kann das Trägerelement 31 in horizontaler Richtung und parallel zu dem ersten Bauteilereservoir bewegt werden, in dem es über am Boden des Trägerelements 31 angeordnete Führungselemente in die Führungsschiene 31 c eingreift und entlang dieser hin und her bewegbar ist. Die Führungsschiene 31 c ist im Ausführungsbeispiel an einem u-förmigen Sockelelement 35 angeordnet.

Die erfindungsgemäße Vorrichtung 1 umfasst des Weiteren ein Trägerelement 41, welches in vertikaler Richtung parallel zu dem Trägerelement 31 und dem Trägerelement 22 orientiert ist. Das Trägerelement 41 ist im Wesentlichen in seiner Formgestaltung an das Trägerelement 31 angepasst. Es kann jedoch auch vorgesehen sein, dass die Trägerelemente 31 und 41 unterschiedliche Formgestaltungen aufweisen.

Das Trägerelement 41 weist entsprechend dem Trägerelement 31 eine Rahmenstruktur auf, an dessen beiden vertikalen Rahmenelementen Führungsschienen 41 a und 41 b angeordnet sind. Die beiden Führungsschienen 41 a und 41 b sind im Wesentlichen vertikal orientiert. An dem Trägerelement 41 ist ein optisches System angeordnet, welches eine Kamera (nicht dargestellt) umfasst, welche an bzw. in dem Element 42 fest positioniert ist. Das Element 42 weist Führungselemente auf, die in die Führungsschienen 41 a und 41 b eingreifen und eine Bewegung der Kamera 43 sowie des Elements 42 in vertikaler Richtung ermöglichen. Die Bewegung erfolgt dabei in einer Ebene parallel zum ersten Bauteilereservoir. Darüber hinaus ist das Trägerelement 41 an seiner Bodenseite mit Führungselementen mit einer Führungsschiene 41 c bewegbar verbunden. Die Führungsschiene 41 c ist parallel zu der Führungsschiene 31 c angeordnet und ermöglicht ein Bewegen des Trägerelements 41 in horizontaler Richtung parallel zum ersten Bauteilereservoir.

Wie aus dem Ausführungsbeispiel in Figur 1 zu erkennen ist, ist das Trägerelement 31 und die daran angeordneten Elemente zwischen dem Trägerelement 41 und der daran bewegbar angeordneten Elemente und dem Trägerelement 22 bzw. dem ersten Bauteilereservoir auf dem Montagetisch 21 angeordnet.

Des Weiteren umfasst die erfindungsgemäße Vorrichtung im Ausführungsbeispiel gemäß Figur 1 ein weiteres rahmenförmig ausgebildetes Trägerelement 51, an dem eine Detektoreinheit 52 bewegbar angeordnet ist. Die Detektoreinheit 52 ist dabei in bzw. auf einem plattenförmigen Element 53 befestigt. An der dem Trägerelement 51 zugewandten Seite des Elements 53 sind Führungselemente angebracht, welche in Führungsschienen 51 a und 51 b eingreifen und ein Verschieben des Elements 53 und der Detektoreinheit 52 in vertikaler Richtung ermöglichen. Des Weiteren sind an der Bodenseite des Trägerelements 51 Führungselemente ausbildet, welche in eine Führungsschiene 51 c eingreifen und ein Verschieben des Trägerelements 51 in horizontaler Richtung parallel zum Trägerelement 22 und zum ersten Bauteilereservoir ermöglicht. Dadurch kann erreicht werden, dass die Detektoreinheit 52 durch die Schienen 51 a bis 51 c in einer Ebene parallel zum ersten Bauteilereservoir bewegbar ist. Mittels der Detektoreinheit 52 kann beispielsweise die Rückseite des auf dem Montagetisch 21 angeordneten ersten Bauteilereservoirs beobachtet und überwacht werden. Diesbezüglich kann beispielsweise des Entnehmen eines elektronischen Bauteils aus einer Aufnahmeposition und/oder das Einführen bzw. das Montieren eines elektronischen Bauteils in einer Montageposition an der Rückseite des ersten Bauteilereservoirs überwacht werden. Es kann jedoch auch vorgesehen sein, dass die Detektoreinheit andere Funktionen oder zusätzlich andere Funktionen durchführen kann. Die Detektoreinheit 52 kann diesbezüglich als Kamera ausgebildet sein.

Wie aus dem Ausführungsbeispiel in Figur 1 zu erkennen ist, ist die erfindungsgemäße Vorrichtung 1 insbesondere für relativ große Bauteilereservoire vorgesehen, insbesondere für 12-Zoll-Wafer. Wie zu erkennen ist, ist lediglich eine feste Positionsvorgabe für das erste Bauteilereservoir vorgesehen. Im Wesentlichen sind alle anderen für ein Überwachen, Aufnehmen, Transportieren und Montieren von elektronischen Bauteilen vorgesehenen Elemente bewegbar angeordnet und insbesondere relativ bewegbar zu dem ersten Bauteilereservoir ausgebildet.

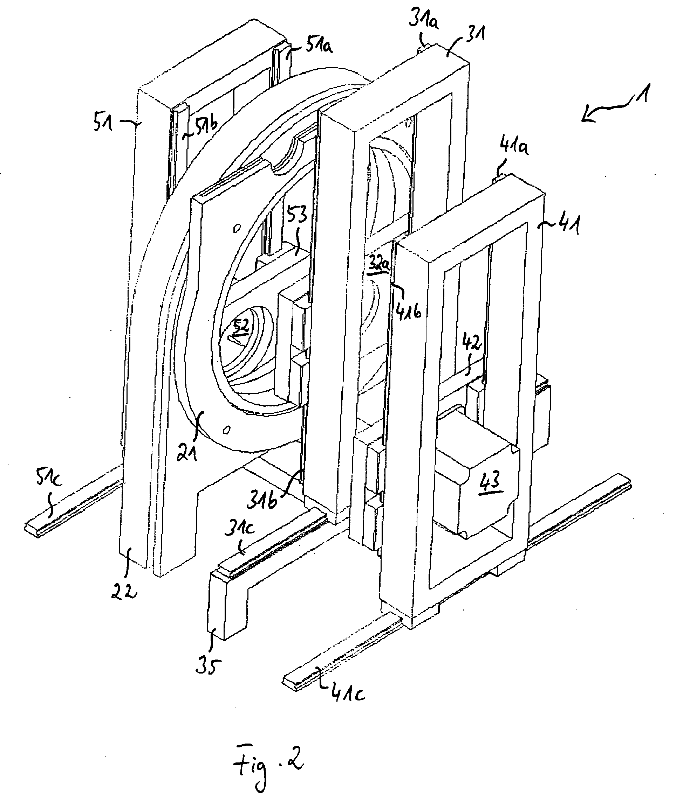

In Figur 2 ist das gemäß Figur 1 gezeigte Ausführungsbeispiel der erfindungsgemäßen Vorrichtung 1 von einer zweiten Betrachtungsposition aus perspektivisch dargestellt. Es sei angemerkt, dass in allen Figuren gleiche oder funktionsgleiche Elemente mit identischen Bezugszeichen versehen sind. Wie aus Figur 2 zu erkennen ist, ist der Montagetisch 21 im Wesentlichen kreisförmig ausgebildet, wobei das erste Bauteilereservoir (nicht dargestellt) auf dem ringförmigen Bereich des Montagetisches 21 befestigbar ist.

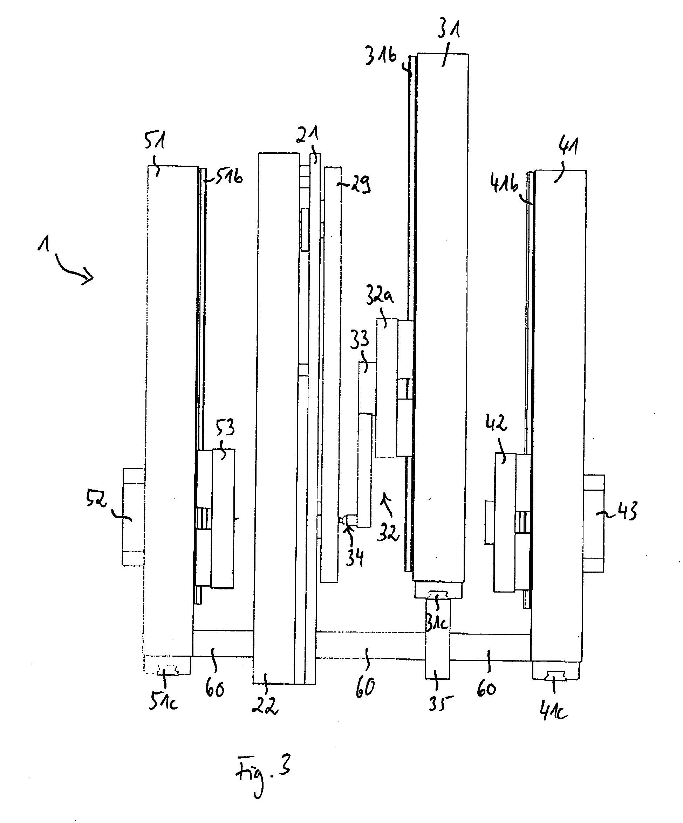

In Figur 3 ist eine Schnittdarstellung des in Figur 1 gezeigten Ausführungsbeispiel entlang der Schnittlinie II dargestellt. Wie aus der gezeigten Schnittdarstellung in Figur 3 zu erkennen ist, ist ein erstes Bauteilereservoir 29 bzw. ein erster Wafer vertikal orientiert. Das erste Bauteilereservoir 29 ist fest auf dem Montagetisch 21 angeordnet. Wie zu erkennen ist, ist das Aufnahme- und Montageelement 34 im Wesentlichen senkrecht zur Oberfläche des ersten Bauteilereservoirs 29 orientiert. Wie des Weiteren aus Figur 3 zu erkennen ist, sind die Trägerelemente 31, 41 und 51 parallel zum Trägerelement 22 und dem ersten Bauteilereservoir 29 angeordnet. Die Trägerelemente 31, 41 und 51 sowie das Trägerelement 22 sind jeweils als separate Trägerelemente ausgebildet. Dadurch kann eine Modulbauweise der erfindungsgemäßen Vorrichtung 1 erreicht werden. Die separaten Trägerelement 31, 41, 51 und 22 mit den entsprechend daran angeordneten Elementen können dadurch in einfacher Weise jeweils separat ausgetauscht bzw. umgebaut oder anders zueinander positioniert werden. Dies kann in sehr schneller und aufwandsarmer Weise durchgeführt werden und ermöglicht eine flexible und variable Einsatzmöglichkeit der erfindungsgemäßen Vorrichtung. Im Ausführungsbeispiel gemäß Figur 3 sind die Trägerelemente 31, 41, 51 an einer gemeinsamen Schiene 60 derart relativ zueinander fest positionierbar, dass die horizontalen Abstände gemäß der Betrachtungsebene in Figur 3 fest sind. Dies bedeutet, dass gemäß der Schnittdarstellung in Figur 3 die horizontalen Abstände zwischen dem Trägerelement 51 und dem Trägerelement 22 während dem Betrieb der erfindungsgemäßen Vorrichtung nicht verändert wird. Die Trägerelemente 31, 41, 51 und 22 können dabei positionsstabil im Hinblick auf die horizontale Verschiebung gemäß der Darstellung in Figur 3 relativ zueinander fest positioniert werden, wodurch das Zusammenwirken der Vorrichtung verbessert werden kann.

## Patentansprüche

1. Vorrichtung zur Montage von elektronischen Bauteilen auf ein Bauteilereservoir (29), insbesondere eine vollautomatische Montagevorrichtung zur Herstellung mikrosystemtechnischer Produkte sowie für Montageaufgaben in der Halbleiterindustrie, mit
- einem ersten Bauteilereservoir (29), welches auf einem ersten Montagetisch (21) ortsfest angeordnet ist und
- einer Aufnahme- und Transporteinheit (32) mit einem Aufnahme- und Montagewerkzeug (33) zur Aufnahme und zum Transport von elektronischen Bauteilen und zur Montage der elektronischen Bauteile auf dem ersten Bauteilereservoir (29), wobei zumindest das Aufnahme- und Montagewerkzeug (32) relativ zum ersten Bauteilereservoir (29) bewegbar angeordnet ist.

2. Vorrichtung nach Anspruch 1,
**dadurch gekennzeichnet , dass**
das erste Bauteilerreservoir (29) im Wesentlichen vertikal angeordnet ist.

3. Vorrichtung nach Anspruch 1 oder 2,
**dadurch gekennzeichnet,dass**
die Aufnahme- und Transporteinheit (32) in einer Ebene, insbesondere einer vertikalen Ebene, parallel zum ersten Bauteilereservoir (29) bewegbar angeordnet ist.

4. Vorrichtung nach einem der vorhergehenden Ansprüche,
**dadurch gekennzeichnet,dass**
das Aufnahme- und Montagewerkzeug (33) derart bewegbar in der Aufnahme- und Transporteinheit (32) angeordnet ist, dass eine Rotationsbewegung des Aufnahme- und Montagewerkzeuges (33) in einer Ebene parallel zum ersten Bauteilereservoir (29) durchführbar ist.

5. Vorrichtung nach einem der vorhergehenden Ansprüche,
**dadurch gekennzeichnet,dass**
die Aufnahme- und Transporteinheit (32) und der Montagetisch (21) mit dem ersten Bauteilereservoir (29) an separaten Trägerelementen (31, 22) angeordnet sind.

6. Vorrichtung nach einem der vorhergehenden Ansprüche,
**dadurch gekennzeichnet,dass**
der Montagetisch (21) an einem separaten Trägerelement (22) angeordnet ist und der Montagetisch (21) und das Trägerelement (22) Aussparungen aufweisen, insbesondere kreisrunde Aussparungen, wobei der Montagetisch (21) und die Aufnahme- und Transporteinheit (32) derart zueinander angeordnet sind, dass die Aussparungen zumindest teilweise überlappen.

7. Vorrichtung nach einem der vorhergehenden Ansprüche,
**dadurch gekennzeichnet,dass**
ein optisches System (43) in einer Ebene parallel zum ersten Bauteilereservoir (29) bewegbar ist.

8. Vorrichtung nach Anspruch 7,
**dadurch gekennzeichnet,dass**
das optische System (43) eine Kamera, insbesondere eine CCD-Kamera, umfasst, welche mit ihrer optischen Achse senkrecht zur Oberfläche des ersten Bauteilereservoirs (29) orientiert ist.

9. Vorrichtung nach Anspruch 7 oder 8,
**dadurch gekennzeichnet,dass**
das optische System (43) an einem separaten Trägerelement (41) angeordnet ist, insbesondere einem Trägerelement, welches parallel zum ersten Bauteilereservoir (29) und parallel zur Bewegungsebene der Aufnahme- und Transporteinheit (32) angeordnet ist.

10. Vorrichtung nach Anspruch 9,
**dadurch gekennzeichnet,dass**
die Aufnahme- und Transporteinheit (32) zwischen dem ersten Bauteilereservoir (29) und dem optischen System (43) angeordnet ist.

11. Vorrichtung nach einem der vorhergehenden Ansprüche,
**dadurch gekennzeichnet,dass**
eine Detektoreinheit (52) auf der der Aufnahme- und Transporteinheit (32) gegenüberliegenden Seite des ersten Bauteilereservoirs (29) angeordnet ist.

12. Vorrichtung nach Anspruch 11,
**dadurch gekennzeichnet,dass**
die Detektoreinheit (52) in einer Ebene parallel zum ersten Bauteilereservoir (29) bewegbar angeordnet ist und an einem separaten Trägerelement (51) angeordnet ist.

13. Verfahren zur Montage von elektronischen Bauteilen auf ein Bauteilereservoir (29), insbesondere mit eine vollautomatische Montagevorrichtung zur Herstellung mikrosystemtechnischer Produkte, bei dem
- ein erstes Bauteilereservoir (29) auf einem ersten Montagetisch (21) ortsfest angeordnet wird und
- zumindest eine Aufnahme- und Transporteinheit (32) mit einem Aufnahme- und Montagewerkzeug (33, 34) zur Aufnahme und den Transport von elektronischen Bauteilen und zur Montage der elektronischen Bauteile auf dem ersten Bauteilereservoir (29) relativ zum ersten Bauteilereservoir (29) bewegt wird.

14. Verfahren nach Anspruch 13,
**dadurch gekennzeichnet,dass**
das erste Bauteilereservoir (29) im Wesentlichen vertikal positioniert wird und die Aufnahme- und Transporteinheit (32) in einer vertikalen Ebene parallel zum ersten Bauteilereservoir (29) bewegt wird.

15. Verfahren nach Anspruch 13 oder 14,
**dadurch gekennzeichnet,dass**
das erste Bauteilereservoir (29) und die Aufnahme- und Transporteinheit (32) an separaten Trägerelementen (22, 31) angeordnet werden.
